# EUROPEAN PATENT APPLICATION

(11) **EP 4 318 599 A1**
(43) Date of publication of application: **07.02.2024**
(21) Application number: 22841404.1
(22) Date of filing: 13.07.2022
(51) Int. Cl.: H01L 31/0216, H01L 31/02, H01L 31/20

(54) **SELECTIVE PASSIVATED CONTACT CELL AND PREPARATION METHOD THEREFOR**

(30) Priority: 14.07.2021 CN 202110793522
(71) Applicant: Trina Solar Co., Ltd, Changzhou, Jiangsu 213031 (CN)
(72) Inventor: ZHANG, Xueling, Hangzhou, Jiangsu 213031 (CN); LIU, Wei, Hangzhou, Jiangsu 213031 (CN); LIU, Chengfa, Hangzhou, Jiangsu 213031 (CN); CHEN, Daming, Hangzhou, Jiangsu 213031 (CN)
(74) Representative: Canzler & Bergmeier Patentanwälte Partnerschaft mbB
(86) International application number: PCT/CN2022/105405
(87) International publication number: WO 2023/284771

(57) **Abstract**

Provided in the present invention are a selective passivated contact cell and a preparation method therefor. The selective passivated contact cell comprises a substrate, wherein a first silicon oxide layer and a first polysilicon layer are sequentially arranged on the surface of one side of the substrate in a stacked manner; the surface of the substrate comprises a non-metal contact region and at least two metal contact regions; in the metal contact regions, a second silicon oxide layer and a second polysilicon layer are further sequentially arranged on the surface of the side of the first polysilicon layer that is away from the substrate, and a first electrode is arranged on the second polysilicon layer; and the thickness of the first polysilicon layer that is located in the metal contact regions is greater than the thickness of the first polysilicon layer that is located in the non-metal contact region. By means of providing a thick polysilicon layer in a metal contact region so as to block corrosion of a metal slurry, and forming a thin polysilicon layer in a non-metal contact region so as to reduce light absorption, the present invention has the characteristics of a simple structure, a simple preparation process, a high efficiency, etc.

## Description

### TECHNICAL FIELD

The present disclosure belongs to the technical field of solar cells, and particularly relates to a selective passivated contact cell and a preparation method therefor.

### BACKGROUND

With the continuous development of the solar cell technology, the solar cell efficiency is approaching the theoretical limit. The N-type i-TOPCon solar cell, due to a good passivation contact structure on the back side, has become one of the high-efficiency cells and reached an area cell efficiency of 25.8%. The average efficiency of large-area industrialized cells has exceeded 24%.

CN111540794A discloses a P-type passivated contact solar cell in which a front grid line, a front epitaxial layer, an N-type diffusion layer, a P-type matrix silicon, a back epitaxial layer and a back grid line are sequentially arranged in contact with each other from a light-facing surface to a shady surface; the front epitaxial layer includes a front contact passivation layer and a front covering passivation layer; the front contact passivation layer is positioned in a metal region on a front side of the P -type passivated contact solar cell; the front covering passivation layer is positioned in a non-metal region on the front side; and the front contact passivation layer sequentially includes, from the light-facing surface to the shady surface, a phosphorus-doped polysilicon layer and a first silicon dioxide layer. This invention reduces a recombination rate at a joint of the metal and the semiconductor and improves the power generation efficiency of the cell, and, since the metal region occupies merely a small part of the whole surface of the solar cell, improves the power generation efficiency of the cell chip.

CN209104161U discloses a selective passivated contact solar cell, including a silicon wafer, and a positive electrode on a front side of the silicon wafer, wherein a first antireflection film layer, a doped polysilicon layer, and a passivation tunneling layer are sequentially arranged between the positive electrode and the silicon wafer; and the positive electrode passes through the first antireflection film layer and the doped polysilicon layer, into contact with the passivation tunneling layer. The passivation tunneling layer, the doped polysilicon layer and the first antireflection film layer of the utility model are positioned between the positive electrode and the silicon wafer, so that the passivation effect is effectively exerted while the non-electrode region is not shielded, the absorption of solar energy by the conventional doped silicon layer is reduced, and the efficiency of the solar cell is improved.

CN108807565A discloses a passivated contact electrode structure, including a doped semiconductor layer deposited on a crystalline silicon substrate, and a copper electrode on the doped semiconductor layer; wherein the doped semiconductor layer is made of any one of polysilicon, microcrystalline silicon or microcrystalline silicon-carbon alloy, and has a thickness of 5 to 100nm. The solar cell includes the passivated contact electrode structure on a back side or both sides of the crystalline silicon substrate. By passivating contact part of all metal electrodes, a surface recombination efficiency of photogenerated carriers is reduced, and a more thorough passivation effect is achieved.

For a solar cell of the existing art, the polysilicon layer has severe parasitic absorption to light in the passivated contact structure, and a thick polysilicon layer grown over the surface of the silicon wafer may greatly reduce a utilization rate of light by the cell and a short-circuit current for the cell. Therefore, how to effectively reduce recombination of the metal and non-metal regions while ensuring the utilization rate of light by the cell has now become an urgent problem to be solved.

### SUMMARY

In order to solve the defects in the existing art, an object of the present disclosure is to provide a selective passivated contact cell and a preparation method therefor, which can provide a thicker polysilicon layer in the metal contact regions to block corrosion of a metal slurry, and form a thinner polysilicon layer in the non-metal contact region to reduce light absorption; and provide a second silicon oxide layer in the middle of a second polysilicon layer to protect the second polysilicon layer, and thus have the advantages of simple structure, simple preparation process, high efficiency, and the like.

In order to achieve this object, the present disclosure adopts the following technical solutions:
In a first aspect, the present disclosure provides a selective passivated contact cell, including a substrate, wherein a first silicon oxide layer and a first polysilicon layer are sequentially arranged on a side surface of the substrate in a stacked manner, wherein a surface of the substrate has a non-metal contact region and at least two metal contact regions. in each of the metal contact regions, a second silicon oxide layer and a second polysilicon layer are further arranged sequentially on a side surface of the first polysilicon layer away from the substrate, and a first electrode is provided on the second polysilicon layer; and the first polysilicon layer has a greater thickness in the metal contact regions than in the non-metal contact region.

By providing the second silicon oxide layer, the present disclosure can effectively control the etching rate and ensure uniform etching. Further, by providing the first polysilicon layer having a greater thickness in the metal contact regions than in the non-metal contact region, the thicker first polysilicon layer in the metal contact regions can effectively prevent the corrosion of a metal slurry and increase a voltage and a filling factor, while the thinner first polysilicon layer in the non-metal contact region can effectively reduce the light absorption and increase the current. The present disclosure can effectively improve the photoelectric efficiency of the cell, has the advantages of simple structure, simple preparation process, high efficiency, and the like, and can effectively reduce recombination of the metal and non-metal regions while ensuring the utilization rate of light by the cell. Moreover, preparation of such a structure is well repeatable.

As a preferred technical solution of the present disclosure, the second polysilicon layer has a grid structure that is the same as a grid structure of the first electrode.

With the second polysilicon layer having a grid structure matched with the grid structure of the first electrode, the present disclosure can further optimize the selective passivated contact structure, and improve the utilization rate of light by the cell.

As a preferred technical solution of the present disclosure, the selective passivated contact cell further includes a first passivation layer and a second passivation layer, wherein the first passivation layer is positioned on a surface of the first polysilicon layer in the non-metal contact region and a surface of the second polysilicon layer, and the second passivation layer is positioned on a side surface of the substrate away from the first silicon oxide layer.

Preferably, the selective passivated contact cell further includes a diffusion layer between the substrate and the first silicon oxide layer, or between the substrate and the second passivation layer.

Preferably, at least two second electrodes are provided on the side surface of the substrate away from the first silicon oxide layer. As a preferred technical solution of the present disclosure, the first polysilicon layer in the metal contact regions has a thickness of 10 to 450nm, for example, 10nm, 50nm, 100nm, 150nm, 200nm, 250nm, 300nm, 350nm, 400nm or 450nm.

Preferably, the first polysilicon layer in the non-metal contact region has a thickness of 1 to 150nm, for example, 1nm, 10nm, 20nm, 30nm, 40nm, 50nm, 60nm, 70nm, 80nm, 90nm, 100nm, 110nm, 120nm, 130nm, 140nm or 150nm, preferably 10 to 25nm.

As a preferred technical solution of the present disclosure, the first silicon oxide layer has a thickness of 0.5 to 5nm, for example, 0.5nm, 1.0nm, 1.5nm, 2.0nm, 2.5nm, 3.0nm, 3.5nm, 4.0nm, 4.5nm or 5.0nm.

Preferably, the second silicon oxide layer has a thickness of 0.5 to 5nm, for example, 0.5nm, 1.0nm, 1.5nm, 2.0nm, 2.5nm, 3.0nm, 3.5nm, 4.0nm, 4.5nm or 5.0nm.

Preferably, the second polysilicon layer has a thickness of 1 to 300nm, for example, 1nm, 30nm, 60nm, 90nm, 120nm, 150nm, 180nm, 210nm, 240nm, 270nm or 300nm.

As a preferred technical solution of the present disclosure, the first passivation layer has a thickness of 30 to 200nm, for example, 30nm, 40nm, 60nm, 80nm, 100nm, 120nm, 140nm, 160nm, 180nm or 200nm.

Preferably, the second passivation layer has a thickness of 30 to 200nm, for example, 30nm, 40nm, 60nm, 80nm, 100nm, 120nm, 140nm, 160nm, 180nm or 200nm.

Preferably, the first passivation layer includes at least one first passivation layer film.

Preferably, the first passivation layer film is made of a material including any one of, or any combination of at least two of, silicon oxide, aluminum oxide, silicon oxynitride, silicon nitride, or silicon carbide.

Preferably, the second passivation layer includes at least one second passivation layer film.

Preferably, the second passivation layer film is made of a material including any one of, or any combination of at least two of, silicon oxide, aluminum oxide, silicon oxynitride, silicon nitride, or silicon carbide.

In a second aspect, the present disclosure provides a preparation method for the selective passivated contact cell according to the first aspect, the preparation method including:
providing a first silicon oxide layer and a first polysilicon layer on a side surface of a substrate, etching such that the first polysilicon layer having a greater thickness in metal contact regions than in a non-metal contact region, sequentially arranging a second silicon oxide layer and a second polysilicon layer on a surface of the first polysilicon layer in the metal contact regions, and providing a first electrode on the second polysilicon layer.

By providing the first polysilicon layer having a greater thickness in the metal contact regions than in the non-metal contact region through etching, the present disclosure can effectively reduce recombination of the metal and non-metal regions while reducing the light absorption of the polysilicon layer in the non-metal contact region, and increase the short-circuit current for the cell. Further, compared with the method of depositing different thicknesses of polysilicon layer for multiple times, the present disclosure can deposit the polysilicon layer in one step and obtain two different thicknesses of polysilicon layer by etching, thereby saving the production cost.

As a preferred technical solution of the present disclosure, the preparation method specifically includes:
(I) performing surface finishing a surface of the substrate to form a diffusion layer on the surface of the substrate, and sequentially arranging a first silicon oxide layer, a first polysilicon layer, a second silicon oxide layer and a second polysilicon layer on a surface of the diffusion layer or a side surface of the substrate away from the diffusion layer;
(II) coating a blocking slurry pattern of the same shape as the first electrode on a surface of the second polysilicon layer, and etching the first polysilicon layer so that the first polysilicon layer has a greater thickness in metal contact regions than in a non-metal contact region;
(III) depositing a protective film on one side of the selective passivated contact cell close to the second polysilicon layer, removing a thin film layer on a side surface of the selective passivated contact cell away from the second polysilicon layer, and then removing the protective film; and
(IV) depositing a first passivation layer and a second passivation layer, and printing a first electrode and a second electrode.

It should be noted that when there is no thin film layer on the side surface of the selective passivated contact cell away from the second polysilicon layer, i.e., when no thin film layer needs to be removed, the step (III) may be omitted, and a person skilled in the art may reasonably select whether to perform the step (III) according to the actual situation of the structure.

As a preferred technical solution of the present disclosure, in the step (I), the surface finishing includes boron doping and /or phosphorus doping.

In the present disclosure, a P-N junction is formed by boron doping.

Preferably, the diffusion layer has a sheet resistance of 80 to 250 ohm/sq, for example, 80 ohm/sq, 90 ohm/sq, 100 ohm/sq, 110 ohm/sq, 120 ohm/sq, 130 ohm/sq, 140 ohm/sq, 150 ohm/sq, 160 ohm/sq, 170 ohm/sq, 180 ohm/sq, 190 ohm/sq, 200 ohm/sq, 210 ohm/sq, 220 ohm/sq, 230 ohm/sq, 240 ohm/sq, or 250 ohm/sq.

Preferably, the side surface of the substrate away from the diffusion layer is subjected to cleaning, including etching to remove an oxide film.

Preferably, the first polysilicon layer and /or the second polysilicon layer are formed by diffusion doping (preferably boron diffusion doping) and high temperature annealing.

As a preferred technical solution of the present disclosure, in the step (III), the protective film has a thickness of 2 to 200nm, for example, 2nm, 20nm, 40nm, 60nm, 80nm, 100nm, 120nm, 140nm, 160nm, 180nm, or 200nm.

Preferably, the protective film is made of a material including any one of, or any combination of at least two of, silicon oxide, silicon carbide, silicon oxynitride or silicon nitride.

Preferably, in the step (III), the method for removing the thin film layer includes removing by hydrofluoric acid. Preferably, the first electrode is sintered after being printed.

Illustratively, there is provided a preparation method for the selective passivated contact cell as described above, the preparation method including:
(I) performing phosphorus doping on a surface of a substrate to form a diffusion layer with a sheet resistance of 80 to 250 ohm/sq on the surface of the substrate, and sequentially arranging a first silicon oxide layer, a first polysilicon layer, a second silicon oxide layer and a second polysilicon layer on a surface of the diffusion layer, wherein the first polysilicon layer and /or the second polysilicon layer are formed by phosphorus diffusion doping and high temperature annealing;
(II) coating a blocking slurry pattern of the same shape as the first electrode on a surface of the second polysilicon layer, and etching the first polysilicon layer so that the first polysilicon layer has a greater thickness in metal contact regions than in a non-metal contact region;
(III) depositing a protective film with a thickness of 2 to 200nm on one side of the selective passivated contact cell close to the second polysilicon layer, and removing a thin film layer on a side surface of the selective passivated contact cell away from the second polysilicon layer with hydrofluoric acid; and
(IV) depositing a first passivation layer and a second passivation layer, and printing and sintering a first electrode and a second electrode.

Optionally, the selective passivated contact cell provided by the present disclosure can also be used for preparing an N-type front junction cell with a selective thickness of P-type polysilicon (P-Poly) on the front side, or a selective thickness of polysilicon structure on both sides, and a person skilled in the art may make reasonable selections and settings according to the type of the cell. In the case of an N-type back junction cell, a selective thickness of N-type polysilicon (N-Poly) is prepared on the front side of the cell, or a selective thickness of P-Poly is prepared on the back side of the cell, or a selective thickness of polysilicon structure is provided on both sides. In the case of a P-type front junction cell, a selective thickness of N-Poly is prepared on the front side of the cell, or a selective thickness of P-Poly is prepared on the back side of the cell, or a selective thickness of polysilicon structure is provided on both sides. In the case of a P-type back junction cell, a selective thickness of P-Poly is provided on the front side of the P-type cell, or a selective thickness of N-Poly is provided on the back side, or a selective thickness of polysilicon structure is provided on both sides.

The numerical ranges set forth herein include not only the recited values but also any value within the recited numerical ranges not enumerated herein, and specific values included in the recited numerical ranges are not exhaustively listed herein in view of brevity and clarity.

Compared with the existing art, the present disclosure has the following beneficial effects:
By providing the second silicon oxide layer, the present disclosure can effectively control the etching rate and ensure uniform etching. Further, by providing the first polysilicon layer having a greater thickness in the metal contact regions than in the non-metal contact region, the thicker first polysilicon layer in the metal contact regions can effectively prevent the corrosion of a metal slurry and increase a voltage and a filling factor, while the thinner first polysilicon layer in the non-metal contact region can effectively reduce the light absorption and increase the current. The present disclosure can effectively improve the photoelectric efficiency of the cell, has the advantages of simple structure, simple preparation process, high efficiency, and the like, and can effectively reduce recombination of the metal and non-metal regions while ensuring the utilization rate of light by the cell. Moreover, preparation of such a structure is well repeatable.

### BRIEF DESCRIPTION OF DRAWINGS

FIG. 1 is a schematic structural diagram of a selective passivated contact cell according to a specific embodiment of the present disclosure, with a diffusion layer between a substrate and a first silicon oxide layer; and
FIG. 2 is a schematic structural diagram of a selective passivated contact cell according to a specific embodiment of the present disclosure, with a diffusion layer between a substrate and a second passivation layer.

In the drawings: 1 - substrate; 2 - first silicon oxide layer; 3 - first polysilicon layer; 4 - second silicon oxide layer; 5 - second polysilicon layer; 6 - first passivation layer; 7 - first electrode; 8 - diffusion layer; 9 - second passivation layer; and 10 - second electrode.

### DETAIL DESCRIPTION OF EMBODIMENTS

It is to be understood that in the description of the present disclosure, the terms "central", "longitudinal", "lateral", "upper", "lower", "front", "rear", "left", "right", "vertical", "horizontal", "top", "bottom", "inner", "outer", and the like indicate an orientation or positional relationship based on the orientation or positional relationship shown in the drawings, and are merely used for facilitating and simplifying description of the present disclosure, instead of indicating or implying that the referred device or element is necessarily in a specific orientation, or constructed and operated in the specific orientation, and therefore, they should not be construed as limitations to the present disclosure. Furthermore, the terms "first", "second", and the like are used for descriptive purposes only and are not to be construed as indicating or implying relative importance or to implicitly indicate a number of the indicated technical features. Therefore, a feature defined by "first", "second" and the like may include one or more of the indicated feature either explicitly or implicitly. In the description of the present disclosure, "a plurality" means two or more unless otherwise specified.

It should be noted that, unless explicitly stated or defined otherwise, the terms "disposed", "connected" and "connect" in the description of the present disclosure are to be construed broadly and may include, for example, fixed connection, detachable connection, or integral connection; or may include mechanical or electrical connection; or may include direct connection, indirect connection via an intermedium, or internal communication between two elements. The specific meanings of the above terms in the present disclosure may be understood by those of ordinary skill in the art as the case may be.

The technical solution of the present disclosure will be further described below by way of specific embodiments.

In a specific embodiment, the present disclosure provides a selective passivated contact cell including a substrate 1, wherein a first silicon oxide layer 2 and a first polysilicon layer 3 are sequentially arranged on a side surface of the substrate 1 in a stacked manner. A surface of the substrate 1 includes a non-metal contact region and at least two metal contact regions. In each of the metal contact regions, a second silicon oxide layer 4 and a second polysilicon layer 5 are further arranged sequentially on a side surface of the first polysilicon layer 3 away from the substrate 1, and a first electrode 7 is provided on the second polysilicon layer 5; and the first polysilicon layer 3 has a greater thickness in the metal contact regions than in the non-metal contact region.

By providing the second silicon oxide layer 4, the present disclosure can effectively control the etching rate and ensure uniform etching. Further, by providing the first polysilicon layer 3 having a greater thickness in the metal contact regions than in the non-metal contact region, the thicker first polysilicon layer 3 in the metal contact regions can effectively prevent the corrosion of a metal slurry and increase a voltage and a filling factor, while the thinner first polysilicon layer 3 in the non-metal contact region can effectively reduce the light absorption and increase the current. The present disclosure can effectively improve the photoelectric efficiency of the cell, has the advantages of simple structure, simple preparation process, high efficiency, and the like, and can effectively reduce recombination of the metal and non-metal regions while ensuring the utilization rate of light by the cell. Moreover, preparation of such a structure is well repeatable.

Further, the second polysilicon layer 5 has a grid structure that is the same as a grid structure of the first electrode 7. With the second polysilicon layer 5 having a grid structure matched with the grid structure of the first electrode 7, the present disclosure can further optimize the selective passivated contact structure, and improve the utilization rate of light by the cell.

Further, the selective passivated contact cell further includes a first passivation layer 6 and a second passivation layer 9. The first passivation layer 6 is positioned on a surface of the first polysilicon layer 3 in the non-metal contact region and a surface of the second polysilicon layer 5, and the second passivation layer 9 is positioned on a side surface of the substrate 1 away from the first silicon oxide layer 2.

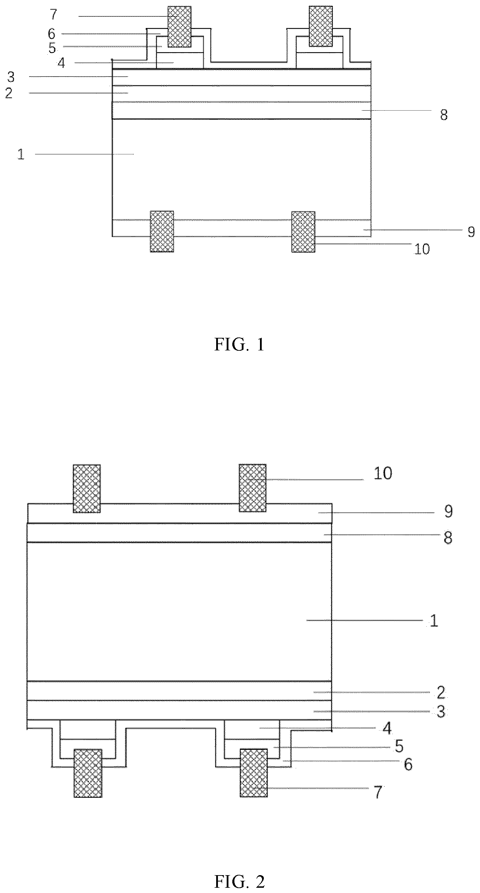

Further, the selective passivated contact cell further includes a diffusion layer 8. The diffusion layer 8 is positioned between the substrate 1 and the first silicon oxide layer 2, as shown in FIG. 1, or positioned between the substrate 1 and the second passivation layer 9, as shown in FIG. 2.

Further, at least two second electrodes 10 are provided on the side surface of the substrate 1 away from the first silicon oxide layer 2.

Further, the first polysilicon layer 3 in the metal contact regions has a thickness of 10 to 450nm; and the first polysilicon layer 3 in the non-metal contact region has a thickness of 1 to 150nm. The first silicon oxide layer 2 has a thickness of 0.5 to 5nm. The second silicon oxide layer 4 has a thickness of 0.5 to 5nm. The second polysilicon layer 5 has a thickness of 1 to 300nm. The first passivation layer 6 has a thickness of 30 to 200nm. The second passivation layer 9 has a thickness of 30 to 200nm.

Further, the first passivation layer 6 includes at least one first passivation layer 6 film made of a material including any one of, or any combination of at least two of, silicon oxide, aluminum oxide, silicon oxynitride, silicon nitride, or silicon carbide; and the second passivation layer 9 includes at least one second passivation layer 9 film made of a material including any one of, or any combination of at least two of, silicon oxide, aluminum oxide, silicon oxynitride, silicon nitride, or silicon carbide.

In another specific embodiment, the present disclosure provides a preparation method for the selective passivated contact cell as described above, the preparation method including:
(I) performing boron doping on a surface of a substrate 1 to form a boron diffusion layer 8 with a sheet resistance of 80 to 250 ohm/sq on the surface of the substrate 1, and sequentially arranging a first silicon oxide layer 2, a first polysilicon layer 3, a second silicon oxide layer 4 and a second polysilicon layer 5 on a side surface of the substrate 1 away from the diffusion layer 8, where the first polysilicon layer 3 and /or the second polysilicon layer 5 are formed by phosphorus diffusion doping and high temperature annealing; or form a boron diffusion layer 8 with a sheet resistance of 80 to 250 ohm/sq on the surface of the substrate 1, and sequentially arranging a first silicon oxide layer 2, a first polysilicon layer 3, a second silicon oxide layer 4 and a second polysilicon layer 5 on the diffusion layer 8, where the first polysilicon layer 3 and /or the second polysilicon layer 5are formed by boron diffusion doping and high temperature annealing;
(II) coating a blocking slurry pattern of the same shape as the first electrode 7 on a surface of the second polysilicon layer 5, and etching the first polysilicon layer 3 so that the first polysilicon layer 3 has a greater thickness in metal contact regions than in a non-metal contact region;
(III) depositing a protective film with a thickness of 2 to 200nm on one side of the selective passivated contact cell close to the second polysilicon layer 5, removing a thin film layer on a side surface of the selective passivated contact cell away from the second polysilicon layer 5 with hydrofluoric acid, and then removing the protective film; and
(IV) depositing a first passivation layer 6 and a second passivation layer 9, and printing and sintering a first electrode 7 and a second electrode 10.

The selective passivated contact cell provided by the present disclosure can also be used for preparing an N-type front junction cell with a selective thickness of P-type polysilicon (P-Poly) on the front side, or a selective thickness of polysilicon structure on both sides, and a person skilled in the art may make reasonable selections and settings according to the type of the cell. In the case of an N-type back junction cell, a selective thickness of N-type polysilicon (N-Poly) is prepared on the front side of the cell, or a selective thickness of P-Poly is prepared on the back side of the cell, or a selective thickness of polysilicon structure is provided on both sides. In the case of a P -type front junction cell, a selective thickness of N-Poly is prepared on the front side of the cell, or a selective thickness of P-Poly is prepared on the back side of the cell, or a selective thickness of polysilicon structure is provided on both sides. In the case of a P-type back junction cell, a selective thickness of P-Poly is provided on the front side of the P-type cell, or a selective thickness of N-Poly is provided on the back side, or a selective thickness of polysilicon structure is provided on both sides.

### Example 1

This example provides a selective passivated contact cell which is based on the selective passivated contact cell described in any of the above specific embodiments, in which a surface of the substrate 1 has two metal contact regions, the diffusion layer 8 is positioned between the substrate 1 and the first silicon oxide layer 2, and two second electrodes 10 are provided on a side surface of the substrate 1 away from the first silicon oxide layer 2.

The first polysilicon layer 3 in the metal contact regions has a thickness of 230nm; and the first polysilicon layer 3 in the non-metal contact region has a thickness of 75nm. The first silicon oxide layer 2 has a thickness of 2.5nm. The second silicon oxide layer 4 has a thickness of 2.5nm. The second polysilicon layer 5 has a thickness of 150nm. The first passivation layer 6 has a thickness of 115nm. The second passivation layer 9 has a thickness of 115nm.

The first passivation layer 6 includes a first passivation layer 6 film made of a material including silicon oxide. The second passivation layer 9 includes a second passivation layer 9 film made of a material including silicon oxide.

This example further provides a preparation method for the selective passivated contact cell as described above, the method including:
(I) performing boron doping on a surface of a substrate 1 to form a diffusion layer 8 with a sheet resistance of 165 ohm/sq on the surface of the substrate 1, and sequentially arranging a first silicon oxide layer 2, a first polysilicon layer 3, a second silicon oxide layer 4 and a second polysilicon layer 5 on a surface of the diffusion layer 8, where the first polysilicon layer 3 and the second polysilicon layer 5are each formed by boron diffusion doping;
(II) coating a blocking slurry pattern of the same shape as the first electrode 7 on a surface of the second polysilicon layer 5, and etching the first polysilicon layer 3 so that the first polysilicon layer 3 has a greater thickness in metal contact regions than in a non-metal contact region;
(III) depositing a protective film with a thickness of 100nm on one side of the selective passivated contact cell close to the second polysilicon layer 5, removing a thin film layer on a side surface of the selective passivated contact cell away from the second polysilicon layer 5 with hydrofluoric acid, and then removing the protective film; and
(IV) depositing a first passivation layer 6 and a second passivation layer 9, and printing and sintering a first electrode 7 and a second electrode 10.

### Example 2

This example provides a selective passivated contact cell which is based on the selective passivated contact cell described in any of the above specific embodiments, in which a surface of the substrate 1 has three metal contact regions, the diffusion layer 8 is positioned between the substrate 1 and the second passivation layer 9, and three second electrodes 10 are provided on a side surface of the substrate 1 away from the first silicon oxide layer 2.

The first polysilicon layer 3 in the metal contact regions has a thickness of 10nm; and the first polysilicon layer 3 in the non-metal contact region has a thickness of 1nm. The first silicon oxide layer 2 has a thickness of 0.5nm. The second silicon oxide layer 4 has a thickness of 0.5nm. The second polysilicon layer 5 has a thickness of 1nm. The first passivation layer 6 has a thickness of 30nm. The second passivation layer 9 has a thickness of 30nm.

The first passivation layer 6 includes two first passivation layer 6 films made of silicon oxynitride and silicon carbide, respectively. The second passivation layer 9 includes two second passivation layer 9 films made of silicon nitride and silicon carbide, respectively.

This example further provides a preparation method for the selective passivated contact cell as described above, the preparation method including:
(I) performing boron doping on a surface of a substrate 1 to form a diffusion layer 8 with a sheet resistance of 80 to 250 ohm/sq on the surface of the substrate 1, and sequentially arranging a first silicon oxide layer 2, a first polysilicon layer 3, a second silicon oxide layer 4 and a second polysilicon layer 5 on a side surface of the substrate 1 away from the diffusion layer 8, where the first polysilicon layer 3 is formed by phosphorus diffusion doping, and the second polysilicon layer 5 is formed by high temperature annealing;
(II) coating a blocking slurry pattern of the same shape as the first electrode 7 on a surface of the second polysilicon layer 5, and etching the first polysilicon layer 3 so that the first polysilicon layer 3 has a greater thickness in metal contact regions than in a non-metal contact region;
(III) depositing a protective film with a thickness of 200nm on one side of the selective passivated contact cell close to the second polysilicon layer 5, removing a thin film layer on a side surface of the selective passivated contact cell away from the second polysilicon layer 5 with hydrofluoric acid, and then removing the protective film; and
(IV) depositing a first passivation layer 6 and a second passivation layer 9, and printing and sintering a first electrode 7 and a second electrode 10.

### Example 3

This example provides a selective passivated contact cell which is based on the selective passivated contact cell described in any of the above specific embodiments, in which a surface of the substrate 1 has four metal contact regions, the diffusion layer 8 is positioned between the substrate 1 and the first silicon oxide layer 2, four second electrodes 10 are provided on a side surface of the substrate 1 away from the first silicon oxide layer 2.

The first polysilicon layer 3 in the metal contact regions has a thickness of 450nm; and the first polysilicon layer 3 in the non-metal contact region has a thickness of 150nm. The first silicon oxide layer 2 has a thickness of to 5nm. The second silicon oxide layer 4 has a thickness of 5nm. The second polysilicon layer 5 has a thickness of 300nm. The first passivation layer 6 has a thickness of 200nm. The second passivation layer 9 has a thickness of 200nm.

The first passivation layer 6 includes three first passivation layer 6 films made of silicon oxide, aluminum oxide and silicon nitride, respectively. The second passivation layer 9 includes three second passivation layer 9 films made of aluminum oxide, silicon oxynitride and silicon carbide, respectively.

This example further provides a preparation method for the selective passivated contact cell as described above, the preparation method including:
(I) performing boron doping on a surface of a substrate 1 to form a diffusion layer 8 with a sheet resistance of 80 to 250 ohm/sq on the surface of the substrate 1, and sequentially arranging a first silicon oxide layer 2, a first polysilicon layer 3, a second silicon oxide layer 4 and a second polysilicon layer 5 on a surface of the diffusion layer 8, where the first polysilicon layer 3 is formed by high temperature annealing, and the second polysilicon layer 5 is formed by boron diffusion doping;
(II) coating a blocking slurry pattern of the same shape as the first electrode 7 on a surface of the second polysilicon layer 5, and etching the first polysilicon layer 3 so that the first polysilicon layer 3 has a greater thickness in metal contact regions than in a non-metal contact region;
(III) depositing a protective film with a thickness of 200nm on one side of the selective passivated contact cell close to the second polysilicon layer 5, removing a thin film layer on a side surface of the selective passivated contact cell away from the second polysilicon layer 5 with hydrofluoric acid, and then removing the protective film; and
(IV) depositing a first passivation layer 6 and a second passivation layer 9, and printing and sintering a first electrode 7 and a second electrode 10.

### Comparative example 1

This comparative example provides a selective passivated contact cell, which is different from example 1 in that the first polysilicon layer 3 has a uniform thickness, i.e., 230nm, in the metal and non-metal contact regions. The rest structures of this comparative example are identical with those in example 1.

This comparative example further provides a preparation method for the selective passivated contact cell as described above, the preparation method including:
(I) performing boron doping on a surface of a substrate 1 to form a diffusion layer 8 with a sheet resistance of 165 ohm/sq on the surface of the substrate 1, and sequentially arranging a first silicon oxide layer 2, a first polysilicon layer 3, a second silicon oxide layer 4 and a second polysilicon layer 5 on a surface of the diffusion layer 8, where the first polysilicon layer 3 and the second polysilicon layer 5are each formed by boron diffusion doping;
(II) coating a blocking slurry pattern of the same shape as the first electrode 7 on a surface of the second polysilicon layer 5, and etching the first polysilicon layer 3 so that the first polysilicon layer 3 has a uniform thickness in the metal and non-metal contact regions;
(III) depositing a protective film with a thickness of 100nm on one side of the selective passivated contact cell close to the second polysilicon layer 5, removing a thin film layer on a side surface of the selective passivated contact cell away from the second polysilicon layer 5 with hydrofluoric acid, and then removing the protective film; and
(IV) depositing a first passivation layer 6 and a second passivation layer 9, and printing and sintering a first electrode 7 and a second electrode 10.

### Comparative example 2

This comparative example provides a selective passivated contact cell, which is different from example 1 in that the second silicon oxide layer 4 is omitted. The rest structures of this comparative example are identical with those in example 1.

### Comparative example 3

This comparative example provides a selective passivated contact cell, which is different from example 1 in that the first polysilicon layer is prepared by a vapor deposition process, and the preparation method includes:
(I) performing boron doping on a surface of a substrate 1 to form a diffusion layer 8 with a sheet resistance of 165 ohm/sq on the surface of the substrate 1, and sequentially arranging a first silicon oxide layer 2, a first polysilicon layer 3, a second silicon oxide layer 4 and a second polysilicon layer 5 on a surface of the diffusion layer 8, where the first polysilicon layer 3 and the second polysilicon layer 5are each formed by boron diffusion doping; where the first polysilicon layer 3 is prepared by a vapor deposition process so that the first polysilicon layer 3 has a uniform thickness in the metal and non-metal contact regions;
(II) depositing a protective film with a thickness of 100nm on one side of the selective passivated contact cell close to the second polysilicon layer 5, and removing a thin film layer on a side surface of the selective passivated contact cell away from the second polysilicon layer 5 with hydrofluoric acid; and
(III) depositing a first passivation layer 6 and a second passivation layer 9, and printing and sintering a first electrode 7 and a second electrode 10.

The solar cells prepared in the above examples and comparative examples are subjected to photoelectric conversion rate performance tests. The test method includes:
placing a prepared solar cell under a simulated light source of AM1.5 (light source simulator model: Newport Oriel 94043A) with a light source energy density of 100mW/cm², where the light source is calibrated with a standard crystalline silicon cell, and testing a J-V curve of the solar cell with FTC 650. The light is directly irradiated on a surface of the solar cell, and an effective area of the solar cell is 0.5cm². The test results are shown in table 1.

**Table 1**

| | Photoelectric conversion rate/% | Short-circuit current/A |
|---|---|---|
| Example 1 | 24.3 | 10.34 |
| Example 2 | 24.5 | 10.36 |
| Example 3 | 24.8 | 10.41 |
| Comparative example 1 | 24.0 | 10.24 |
| Comparative example 2 | 23.8 | 10.21 |
| Comparative example 3 | 24.1 | 10.32 |

From the above table, it can be seen that:
Compared with comparative examples 1 and 2, the photoelectric conversion rate and the short-circuit current effect in example 1 are superior to those of comparative examples 1 and 2. It thereby shows that by providing the second silicon oxide layer 4, the present disclosure can effectively control the etching rate and ensure uniform etching. Further, by providing the first polysilicon layer 3 having a greater thickness in the metal contact regions than in the non-metal contact region, the thicker first polysilicon layer 3 in the metal contact regions can effectively prevent the corrosion of a metal slurry and increase a voltage and a filling factor, while the thinner first polysilicon layer 3 in the non-metal contact region can effectively reduce the light absorption and increase the current. The present disclosure can effectively improve the photoelectric efficiency of the cell, has the advantages of simple structure, simple preparation process, high efficiency, and the like, and can effectively reduce recombination of the metal and non-metal regions while ensuring the utilization rate of light by the cell. Moreover, preparation of such a structure is well repeatable.

Compared with comparative example 3, the photoelectric conversion rate and the short-circuit current effect in example 1 are superior to those of comparative example 3. It thereby shows that by providing the first polysilicon layer 3 having a greater thickness in the metal contact regions than in the non-metal contact region through etching, the present disclosure can effectively reduce recombination of the metal and non-metal regions while reducing the light absorption of the polysilicon layer in the non-metal contact region, and increase the short-circuit current for the cell. Further, compared with the method of depositing different thicknesses of polysilicon layer for multiple times, the present disclosure can deposit the polysilicon layer in one step and obtain two different thicknesses of polysilicon layer by etching, thereby saving the production cost.

The applicant declares that the above describes merely specific embodiments of the present disclosure, and the protection scope of the present disclosure is not limited thereto, and it should be understood by those skilled in the art that any changes or substitutions that can be easily conceived by those skilled in the art within the technical scope of the present disclosure disclosed herein fall within the protection scope and disclosure of the present disclosure.

## Claims

1. A selective passivated contact cell, **characterized in that** the selective passivated contact cell comprises a substrate, wherein a first silicon oxide layer and a first polysilicon layer are sequentially arranged on a side surface of the substrate in a stacked manner, wherein a surface of the substrate has a non-metal contact region and at least two metal contact regions;
in each of the metal contact regions, a second silicon oxide layer and a second polysilicon layer are further arranged sequentially on a side surface of the first polysilicon layer away from the substrate, and a first electrode is provided on the second polysilicon layer; and
the first polysilicon layer has a greater thickness in the metal contact regions than in the non-metal contact region.

2. The selective passivated contact cell according to claim 1, **characterized in that** the second polysilicon layer has a grid structure that is the same as a grid structure of the first electrode.

3. The selective passivated contact cell according to claim 1 or 2, **characterized in that** the selective passivated contact cell further comprises a first passivation layer and a second passivation layer, wherein the first passivation layer is positioned on a surface of the first polysilicon layer in the non-metal contact region and a surface of the second polysilicon layer, and the second passivation layer is positioned on a side surface of the substrate away from the first silicon oxide layer;
the selective passivated contact cell further comprises a diffusion layer between the substrate and the first silicon oxide layer; and
at least two second electrodes are provided on the side surface of the substrate away from the first silicon oxide layer.

4. The selective passivated contact cell according to claim 3, **characterized in that** the diffusion layer is positioned between the substrate and the second passivation layer.

5. The selective passivated contact cell according to claim 1, **characterized in that** the first polysilicon layer in the metal contact regions has a thickness of 10 to 450nm; and the first polysilicon layer in the non-metal contact region has a thickness of 1 to 150nm.

6. The selective passivated contact cell according to claim 5, **characterized in that** the first polysilicon layer in the non-metal contact region has a thickness of 10 to 25nm.

7. The selective passivated contact cell according to claim 1, **characterized in that** the first silicon oxide layer has a thickness of 0.5 to 5nm; the second silicon oxide layer has a thickness of 0.5 to 5nm; and
the second polysilicon layer has a thickness of 1 to 300nm.

8. The selective passivated contact cell according to claim 3, **characterized in that** the first passivation layer has a thickness of 30 to 200nm; and the second passivation layer has a thickness of 30 to 200nm.

9. The selective passivated contact cell according to claim 8, **characterized in that** the first passivation layer comprises at least one first passivation layer film made of a material comprising any one of, or any combination of at least two of, silicon oxide, aluminum oxide, silicon oxynitride, silicon nitride, or silicon carbide; and
the second passivation layer comprises at least one second passivation layer film made of a material comprising any one of, or any combination of at least two of, silicon oxide, aluminum oxide, silicon oxynitride, silicon nitride, or silicon carbide.

10. A preparation method for the selective passivated contact cell according to any of claims 1 to 9, **characterized in that** the preparation method comprises:
providing a first silicon oxide layer and a first polysilicon layer on a side surface of a substrate, etching such that the first polysilicon layer having a greater thickness in metal contact regions than in a non-metal contact region, sequentially arranging a second silicon oxide layer and a second polysilicon layer on a surface of the first polysilicon layer in the metal contact regions, and providing a first electrode on the second polysilicon layer.

11. The preparation method according to claim 10, **characterized in that** the preparation method specifically comprises:
(I) performing surface finishing a surface of the substrate to form a diffusion layer on the surface of the substrate, and sequentially arranging the first silicon oxide layer, the first polysilicon layer, the second silicon oxide layer and the second polysilicon layer on a surface of the diffusion layer or a side surface of the substrate away from the diffusion layer;
(II) coating a blocking slurry pattern of the same shape as the first electrode on a surface of the second polysilicon layer, and etching the first polysilicon layer so that the first polysilicon layer has a greater thickness in the metal contact regions than in the non-metal contact region;
(III) depositing a protective film on one side of the selective passivated contact cell close to the second polysilicon layer, removing a thin film layer on a side surface of the selective passivated contact cell away from the second polysilicon layer, and then removing the protective film; and
(IV) depositing a first passivation layer and a second passivation layer, and printing the first electrode and a second electrode.

12. The preparation method according to claim 11, **characterized in that** in the step (I), the surface finishing comprises boron doping and /or phosphorus doping;
the diffusion layer has a sheet resistance of 80 to 250 ohm/sq;
the side surface of the substrate away from the diffusion layer is subjected to cleaning, comprising etching to remove an oxide film; and
the first polysilicon layer and /or the second polysilicon layer are formed by boron diffusion doping and high temperature annealing.

13. The preparation method according to claim 11, **characterized in that** in the step (III), the protective film has a thickness of 2 to 200nm;
the protective film is made of a material comprising any one of, or any combination of at least two of, silicon oxide, silicon carbide, silicon oxynitride or silicon nitride;
in the step (III), the method for removing the thin film layer comprises removing by hydrofluoric acid; and the first electrode is sintered after being printed.
